# EUROPÄISCHE PATENTSCHRIFT

(11) **EP 3 338 346 B1**
(45) Veröffentlichungstag und Bekanntmachung des Hinweises auf die Patenterteilung: **15.07.2020**
(21) Anmeldenummer: 16745100.4
(22) Anmeldetag: 27.07.2016
(51) Int. Cl.: H02K 5/20, H02K 9/19, H02K 5/15

(54) **KÜHLSYSTEM FÜR EINE ELEKTRISCHE MASCHINE**
COOLING SYSTEM FOR AN ELECTRIC MACHINE
SYSTÈME DE REFROIDISSEMENT POUR MACHINE ÉLECTRIQUE

(30) Priorität: 21.08.2015 DE 102015216055
(43) Veröffentlichungstag der Anmeldung: 27.06.2018
(73) Patentinhaber: Vitesco Technologies GmbH, 30165 Hannover (DE)
(72) Erfinder: FRÖHLICH, Holger, 13127 Berlin (DE); KRAUSE, Robert, 10409 Berlin (DE)
(74) Vertreter: Waldmann, Georg Alexander
(86) Internationale Anmeldenummer: PCT/EP2016/067940
(87) Internationale Veröffentlichungsnummer: WO 2017/032538

(56) Entgegenhaltungen:
- EP-A1- 2 479 874
- EP-A2- 2 731 236
- DE-A1-102005 002 897
- DE-A1-102007 035 271
- FR-A1- 2 999 359
- JP-U- S 605 260
- KR-B1- 100 259 799
- US-A1- 2014 354 089
- US-B2- 8 080 909

## Beschreibung

Die Erfindung betrifft ein Kühlsystem für eine elektrische Maschine, insbesondere einen Elektromotor, z.B. einen Asynchronmotor oder einen Synchronmotor.

Derartige elektrische Maschinen werden für vielfältige Antriebsaufgaben benötigt und erzeugen aufgrund von elektrischen Verlusten wie Wirbelstromverlusten oder Kupferverlusten während ihres Betriebs Verlustwärme. Bei elektrischen Maschinen ist ein leistungsbegrenzender Faktor die Qualität der Abfuhr der erzeugten Verlustwärme. Besonders bei Ausführungen, bei denen temperaturbelastete Teile innerhalb der elektrischen Maschine nicht direkt durch ein Kühlmedium gekühlt werden, ist eine Ausnutzung eingesetzter Aktivmasse unter Umständen nicht optimal. Spezielle Zonen, bei denen eine Abfuhr von Wärme innerhalb einer elektrischen Maschine problematisch sein kann, sind insbesondere Stator-Wickelköpfe und ein Rotor der elektrischen Maschine.

Es ist bekannt, elektrische Maschinen mit einem gasförmigen oder flüssigen Medium zu kühlen. Typischerweise wird als gasförmiges Medium Luft und als flüssiges Medium Wasser verwendet, wobei elektrische Maschinen im Falle einer Flüssigkeitskühlung zumeist durch einen Kühlmantel gekühlt werden. Elektrische Maschinen können ferner eigengekühlt oder fremdgekühlt sein.

Aus der EP 2731236 A1 ist ein Motor bekannt, wobei der Motor ein erstes Gehäuse zur Aufnahme eines Rotors und eines Stators aufweist. Das erste Gehäuse ist in einem zweiten Gehäuse angeordnet, wobei zwischen dem ersten Gehäuse und dem zweiten Gehäuse ein Kühlkanal angeordnet ist.

Die US 8 080 909 B2 zeigt einen im Lagerschild eines elektrischen Motors angeordneten Kühlkanal mit einer labyrinthartigen Ausgestaltung.

In der JP S60 5260 U ist eine elektrische Maschine mit einem im Lagerschild ausgebildeten Kühlkanal gezeigt, wobei dieser eine in Umfangsrichtung des Lagerschilds ausgebildete mäanderförmige Ausgestaltung aufweist.

Es ist eine Aufgabe der vorliegenden Erfindung, ein Kühlsystem der eingangs genannten Art bereitzustellen, welches eine verbesserte Kühlung der elektrischen Maschine, insbesondere derer Wickelköpfe, ermöglicht.

Die Aufgabe wird gelöst durch die Gegenstände der unabhängigen Patentansprüche. Vorteilhafte Ausführungsformen sind Gegenstand der abhängigen Ansprüche, der folgenden Beschreibung sowie der Figuren.

Das erfindungsgemäße Kühlsystem für eine elektrische Maschine nach Anspruch 1 umfasst wenigstens einen Lagerschild und wenigstens eine Kühlmittelverteilerplatte. Der Lagerschild und die Kühlmittelverteilerplatte sind dazu eingerichtet, gemeinsam einen Kühlkanal auszubilden. Dazu umfasst der Kühlkanal jeweils mehrere unterschiedlich verlaufende Kühlkanalabschnitte, nämlich mehrere horizontale Kühlkanalabschnitte, welche parallel zu einer Drehachse der elektrischen Maschine verlaufen, mehrere vertikale Kühlkanalabschnitte, welche senkrecht zu der Drehachse der elektrischen Maschine verlaufen, und mehrere Umfangskühlkanalabschnitte, welche um die Drehachse der elektrischen Maschine herum verlaufen. Die drei unterschiedlichen Kühlkanalabschnitte schließen dabei derart aneinander an, dass der Kühlkanal wenigstens bereichsweise einen dreidimensional mäanderförmigen Verlauf aufweist.

Der dreidimensional mäanderförmige Verlauf kann beispielsweise durch die folgende Abfolge der unterschiedlichen Kühlkanalabschnitte realisiert werden: ein erster Umfangskühlabschnitt verläuft beispielsweise radial betrachtet im Bereich eines Rotors der elektrischen Maschine ein Stück weit um die Drehachse herum und geht in einen ersten vertikalen Abschnitt über, welcher radial nach außen beispielsweise bis zu einem Wickelkopfbereich des Stators verläuft und in einen ersten horizontalen Kühlabschnitt übergeht, welcher sich beispielsweise in axialer Richtung der Wickelköpfe erstreckt. Der horizontale Abschnitt geht in einen zweiten Umfangskühlabschnitt über, welcher radial und axial zu dem ersten Umfangskühlabschnitt versetzt ein Stück weit um die Drehachse herum verläuft und in einen zweiten axialen Kühlabschnitt übergeht, welcher parallel und gegenläufig zu dem ersten axialen Kühlabschnitt verläuft. Der zweite axiale Kühlabschnitt geht in einen zweiten vertikalen Kühlabschnitt über, welcher parallel und gegenläufig zu dem ersten vertikalen Kühlabschnitt verläuft. Dadurch wird ein Abschnitt bzw. eine Schlinge eines dreidimensionalen Mäandermusters gebildet, welches durch eine Aneinanderreihung solcher Abschnitte bzw. Schlingen gebildet werden kann. Ein solches Mäandermuster erstreckt sich bevorzugt vollständig umfänglich oder nahezu vollständig umfänglich, das heißt es liegt im zusammengebauten Zustand von Kühlmittelverteilerplatte und Lagerschild ein dreidimensional radial umlaufender mäanderförmiger Kühlkanal vor, welcher durch horizontale, vertikale und Umfangskühlkanalabschnitte gebildet wird. Durch den Kühlkanal kann ein Kühlmedium geleitet werden, z.B. Öl, Wasser oder Glykol. Es ist jedoch auch der Einsatz anderer Kühlfluide bzw. Kühlflüssigkeiten vorgesehen.

Durch den mäanderförmigen Verlauf des Kühlkanals ist es möglich, dass eine Kühlung im Bereich eines Stator-Wickelkopfs erzeugt wird, welche sowohl parallel zur Drehachse als auch um die Drehachse herum und insbesondere in Umfangsrichtung des Wickelkopfs wirkt. Das erfindungsgemäße Kühlsystem ermöglicht insbesondere, dass Verlustwärme, welche in dem Bereich eines Stator-Wickelkopfs als Hotspot erzeugt wird, besonders effektiv abgeführt werden kann. Die Hotspots als kritische Heißpunkte können somit quasi am Ort ihrer Entstehung gekühlt werden. Dadurch, dass das erfindungsgemäße Kühlsystem ermöglicht, gezielt Wärme aus dem Bereich eines Stator-Wickelkopfs und des Rotors abzuführen, kann die Leistung der zu kühlenden Maschine bei gleich bleibendem Bauvolumen gesteigert werden.

Dadurch, dass sich der Kühlkanal durch eine Montage von Lagerschild und Kühlmittelverteilerplatte erzeugen lässt, lässt sich der Montageaufwand und Fertigungsaufwand der elektrischen Maschine reduzieren. Dadurch, dass die Kühlkanäle nicht in einem Arbeitsgang, z.B. im Kokillenguss, hergestellt werden müssen, sind besonders für die Serienfertigung relativ kostengünstige Fertigungsverfahren, z.B. Druckguss und Fließpressen, ohne Nacharbeit wie beispielsweise Bohr- oder Fräsbearbeiten einsetzbar. Weiterhin basieren die Kühlkanäle zwar auf einer besonders einfachen Konstruktion von Lagerschild und Kühlmittelverteilerplatte, gewährleisten aber dennoch eine optimale Kühlung der Wickelköpfe bzw. der elektrischen Maschine, wodurch eine größere Leistungsausbeute erzielt werden kann.

In einer bevorzugten Weiterbildung der Erfindung ist vorgesehen, dass vertikale Stege und axiale Stege in den Kühlkanal hineinragen, wobei sich die vertikalen Stege und die axialen Stege um die Drehachse der elektrischen Maschine herum mit Abstand zueinander abwechseln und dazu eingerichtet sind, ein Kühlmedium innerhalb des Kühlkanals zu leiten. Mit anderen Worten ragen die Stege derart in den Kühlkanal, dass ein Kühlmedium, welches durch den Kühlkanal fließt, in axialer Richtung bzw. in vertikaler Richtung umgelenkt wird. Beispielsweise kann der Lagerschild die axialen Stege und die Kühlmittelverteilerplatte die axialen Stege aufweisen oder umgekehrt, um im zusammengebauten Zustand der elektrischen Maschine eine entsprechende Kanalführung und Umlenkung zu bewirken.

So kann z.B. durch axiale Stege der Kühlmittelverteilerplatte und vertikale Stege des Lagerschilds im Kühlkanal ein mäanderförmiger dreidimensionaler Kühlkanal gebildet werden. Indem die genannten axialen und vertikalen Stege jeweils abwechselnd in radialer Richtung im Kühlkanal angeordnet sind und in radialer Richtung zueinander versetzt angeordnet sind, entsteht ein Kanal, bei dem das Kühlmedium von einem Zulaufanschluss an einem ersten Ende des Kühlkanals zu einem Ablaufanschluss an einem dem ersten Ende gegenüberliegenden zweiten Ende des Kühlkanals im Wesentlichen in radialer Richtung strömt und an den Enden der Stege in seiner Bewegungsrichtung um in etwa 180° umgelenkt wird.

Weiterhin können axiale Stege der Kühlmittelverteilerplatte in entsprechende Vertiefungen des Lagerschilds eingreifen und umgekehrt.

Weiterhin kann in dem Kühlkanal wenigstens eine Querrippe angeordnet sein. Die Querrippe bewirkt eine Verengung des Strömungsquerschnitts innerhalb des Kühlkanals. Dadurch wird ermöglicht, dass ein Kühlmedium innerhalb des Kühlkanals im Bereich der Querrippe schneller fließen und sich intensiver mischen kann, was zu einer positiven Beeinflussung einer die Wärmeübertragung behindernden Grenzschicht führen kann, indem eine Reduzierung der Dicke der Prandtl-Grenzschicht ermöglicht wird. Weiterhin vergrößern die Querrippen vorteilhaft eine potentielle Wärmeübertragungsaustauschfläche.

Eine Wärmeübertragung durch Konvektion erfolgt im Allgemeinen durch Heranführen heißer Moleküle eines Fluids an eine Oberfläche. Bei diesem Prozess müssen ständig neue Moleküle nachgeführt werden, damit ein Wärmeaustausch erfolgen kann. Je lebhafter die Bewegung eines Fluids ist, desto größer ist auch die Wärmeübertragung durch Konvektion. Ein Ziel einer Optimierung der Wärmeübertragung durch Konvektion ist es daher, eine laminare Strömung in andauernd turbulente Strömungen zu überführen. Bei jeder Strömung bleiben Fluidteilchen an der Wand haften. An ihnen schieben sich andere Teilchen entlang, so dass keine Teilchen quer zu dieser Strömungsrichtung Wärme an die Wand abgeben können. Es handelt sich dann um eine rein laminare Strömung. Die Wärmeübertragung erfolgt nur durch Wärmeleitung. Bei Anordnen von Tabulatoren bzw. Querrippen innerhalb des Kühlkanals bleiben zwar auch Gasteilchen unbeweglich an der Wand haften, aber abhängig von der Wirbelbildung bewegen sich auch Teilchen quer zur Strömungsrichtung und bringen Teilchen zum Wärmeaustausch an die dünne Grenzschicht. Die Strömung ist dann turbulent und die Wärmeübertragung nimmt mit steigender Turbulenz zu.

Ferner kann in dem Kühlkanal wenigstens eine Längsrippe angeordnet sein. Außerdem kann der Kühlkanal wenigstens bereichsweise eine aufgeraute Oberfläche aufweisen. Diese beiden Ausführungsformen ermöglichen vorteilhaft eine Vergrößerung der potentiellen Wärmeübertragungsaustauschfläche.

Weiterhin ist vorgesehen, dass ein Invertergehäuse an der Kühlmittelverteilerplatte anliegt. Durch eine entsprechende Kommunikation von Kühlmedium in den Kühlkanalabschnitten des Kühlkanals wird eine gleichmäßige effiziente Kühlung des Lagerschilds und des Invertergehäuses erzielt. Da der Kühlkanal erfindungsgemäß dreidimensional geführt ist, kann der Wickelkopf umlaufend und eine Schnittstelle zwischen Lagerschild und Invertergehäuse mit einem Radialkugellager einerseits und Steuer- sowie Leistungselektronik andererseits großflächig gekühlt werden.

Gemäß einer weiteren Ausführungsform sind zwei Lagerschilde, zwei Kühlmittelverteilerplatten und eine Kühlmittelübergabeeinrichtung vorgesehen, wobei die Lagerschilde und Kühlmittelverteilerplatten jeweils auf einander gegenüberliegenden axialen Seiten der elektrischen Maschine angeordnet sind, nämlich auf einer Antriebsseite und einer Abtriebsseite der elektrischen Maschine, und die Kühlmittelübergabeeinrichtung eine Verbindungsleitung für Kühlmittel zwischen den Kühlmittelverteilerplatten ausbildet. Bei der Montage von Lagerschild, Kühlmittelverteilerplatte und Invertergehäuse einerseits und Lagerschild sowie Kühlmittelverteilerplatte auf der anderen Seite der elektrischen Maschine wird jeweils ein vorstehend beschriebener Kühlkanal ausgebildet, welcher dreidimensional mäanderförmig und umlaufend um den jeweiligen Stator-Wickelkopf geführt werden kann. Da der Kühlkanal dreidimensional geführt ist, kann der Stator-Wickelkopf umlaufend sowie die Schnittstelle zwischen Lagerschild und Invertergehäuse flächig gekühlt werden.

Eine erfindungsgemäße elektrische Maschine umfasst einen Stator mit einem Stator-Blechpaket, wobei im Stator-Blechpaket Spulenwicklungen mit axial überstehenden Wickelköpfen eingebracht sind, einen Rotor mit einem auf einer Rotorwelle sitzenden Rotor-Blechpaket und ein erfindungsgemäßes, vorstehend beschriebenes Kühlsystem.

Gemäß einer Ausführungsform der erfindungsgemäßen elektrischen Maschine ist vorgesehen, dass wenigstens einer der Wickelköpfe mit einem Kontaktelement umgeben ist. Bei dem Kontaktelement kann es sich z.B. um Gapfiller handeln. Diese Ausführungsform ermöglicht, dass Wärme vom Wickelkopf zu einer Wärmesenke, z.B. einem aktiv gekühlten Lagerschild abgeleitet werden kann. Das Kontaktelement, z.B. der Gapfiller, kann dabei eine thermische Anbindung der Stator-Wickelköpfe an das Kühlsystem übernehmen. Nach einer Lagerschildmontage können radiale und axiale Außenflächen des Wickelkopfs in jeweiligen Ausnehmungen des Lagerschilds aneinander liegen, und zwar insbesondere ohne Lufteinschlüsse und spielfrei. Dadurch wird ein in vorteilhafter Weise besonders guter wärmeleitfähiger Übergang zwischen Wickelkopf und aktiv wassergekühltem Lagerschild ermöglicht und die Entstehung lokaler Heißpunkte im Wickelkopf kann dadurch stark reduziert werden.

Im Folgenden werden Ausführungsbeispiele der Erfindung anhand der Zeichnung näher erläutert. Hierbei zeigt
- Fig. 1: eine schematische Teil-Längsschnittdarstellung einer elektrischen Maschine mit einem Ausführungsbeispiel eines erfindungsgemäßen Kühlkreislaufs,
- Fig. 2: eine perspektivische Explosionsdarstellung einer weiteren elektrischen Maschine mit einem weiteren Ausführungsbeispiel eines erfindungsgemäßen Kühlsystems,
- Fig. 3: Teile der elektrischen Maschine nach Fig. 2 in einer alternativen perspektivischen Explosionsdarstellung,
- Fig. 4: eine vergrößerte perspektivische Ansicht von Teilen nach Fig. 3 mit verdeutlichtem Kühlkanal,
- Fig. 5: eine perspektivische Ansicht einer Kühlmittelverteilerplatte der elektrischen Maschine nach Fig. 2 und
- Fig. 6: eine Seitenansicht eines Lagerschilds der elektrischen Maschine nach Fig. 2.

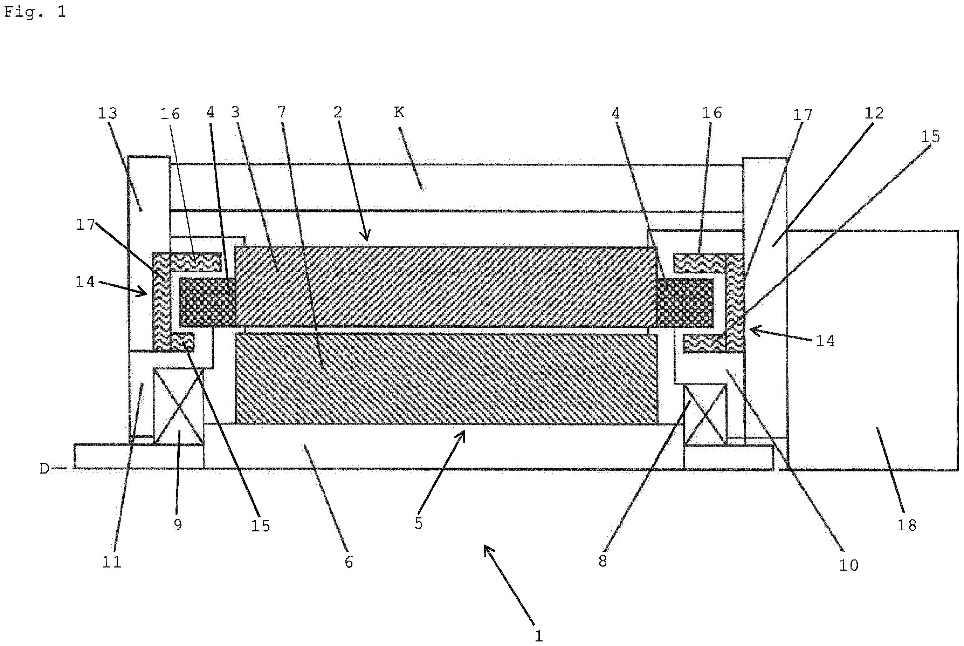

Fig. 1 zeigt den oberen Teil einer elektrischen Maschine 1, welche einen Stator 2 mit einem Stator-Blechpaket 3 umfasst, wobei im Stator-Blechpaket 3 Spulenwicklungen mit axial überstehenden Wickelköpfen 4 eingebracht sind. Weiterhin weist der Stator 2 einen Rotor 5 mit einem auf einer Rotorwelle 6 sitzenden Rotor-Blechpaket 7 auf. Die Rotorwelle 7 ist auf einer in Fig. 1 rechts dargestellten Antriebsseite der elektrischen Maschine 1 in einem ersten Rotorlager 8 gelagert und auf einer in Fig. 1 links dargestellten Abtriebsseite der elektrischen Maschine 1 in einem zweiten Rotorlager 9 gelagert. Ein erster Lagerschild 10 nimmt das erste Rotorlager 8 fest auf und ein zweiter Lagerschild 11 nimmt das zweite Rotorlager 9 fest auf. Der erste Lagerschild 10 ist mit einer ersten Kühlmittelverteilerplatte 12 fest verbunden und der zweite Lagerschild 11 ist mit einer zweiten Kühlmittelverteilerplatte 13 fest verbunden.

Sowohl der erste Lagerschild 10 und die erste Kühlmittelverteilerplatte 12 als auch der zweite Lagerschild 11 und die zweite Kühlmittelverteilerplatte 13 bilden jeweils gemeinsam einen Kühlkanal 14 aus. Der Kühlkanal 14 umfasst jeweils mehrere horizontale Kühlkanalabschnitte 15, 16 umfasst, welche parallel zu einer Drehachse D der elektrischen Maschine 1 verlaufen, mehrere vertikale Kühlkanalabschnitte 17, welche senkrecht zu der Drehachse D der elektrischen Maschine 1 verlaufen, und mehrere in Fig. 1 nicht gezeigte umlaufende Kühlkanalabschnitte, welche um die Drehachse D der elektrischen Maschine 1 herum verlaufen, wobei sich die drei unterschiedlichen Kühlkanalabschnitte 15 bis 17 derart aneinander anschließen, dass der Kühlkanal 14 einen dreidimensionalen mäanderförmigen Verlauf aufweist.

In Fig. 1 ist pro Kühlkanal 14 jeweils einer von mehreren ersten horizontalen Kühlkanalabschnitten 15 zu sehen, welcher radial betrachtet im äußeren Bereich des Rotor-Blechpakets 7 und im inneren Bereich des Wickelkopfs 4 verläuft und sich axial entlang des Wickelkopfs 4 erstreckt. Weiterhin ist in Fig. 1 pro Kühlkanal jeweils einer von mehreren zweiten horizontalen Kühlkanalabschnitten 16 zu sehen, welcher radial betrachtet weiter außen als der erste horizontale Kühlkanalabschnitt 15 verläuft und sich axial entlang eines äußeren Umfangs des Wickelkopfs 4 erstreckt. Die ersten und zweiten Kühlkanalabschnitte 15, 16 verlaufen in axialer Richtung derart parallel zu dem Wickelkopf 4 entlang des ersten Lagerschilds 10, dass der radiale innere Bereich und der radial äußere Bereich des Wickelkopfs in axialer Richtung zu einem Großteil gekühlt werden können, und zwar mittelbar über den ersten Lagerschild und mittels eines innerhalb des Kühlkanals fließenden Kühlmediums, z.B. Wasser, Öl oder Glykol. Weiterhin ist in Fig. 1 pro Kühlkanal 14 jeweils einer von mehreren vertikalen Kühlkanalabschnitten 17 zu sehen, welcher den ersten horizontalen Kühlkanalabschnitt 15 mit dem zweiten horizontalen Kühlkanalabschnitt 16 verbindet. An der ersten Kühlmittelverteilerplatte 12 ist in axialer Richtung seitlich ein Invertergehäuse 18 angeordnet, welches einen nicht dargestellten Inverter aufnimmt. Die vertikalen Kühlkanalabschnitte 17 verlaufen derart, dass der Wickelkopf in radialer Richtung und das Invertergehäuse 18 mittelbar über die Kühlmittelverteilerplatte 12 gekühlt werden können. In Umfangsrichtung des Wickelkopfs 4 sind weitere, nicht dargestellte Kühlkanalabschnitte angeordnet, welche jeweils ineinander übergehen und die dreidimensionale mäanderförmige Form des Kühlkanals 14 entlang eines Großteils des vollen Umfangs des Wickelkopfs 4 ausbilden. Weiterhin ist eine Kühlmittelübergabeeinrichtung K zwischen der ersten Kühlmittelverteilerplatte 12 und der zweiten Kühlmittelverteilerplatte 13 angeordnet und bildet eine Verbindungsleitung für Kühlmittel zwischen den Kühlmittelverteilerplatten 12, 13 aus.

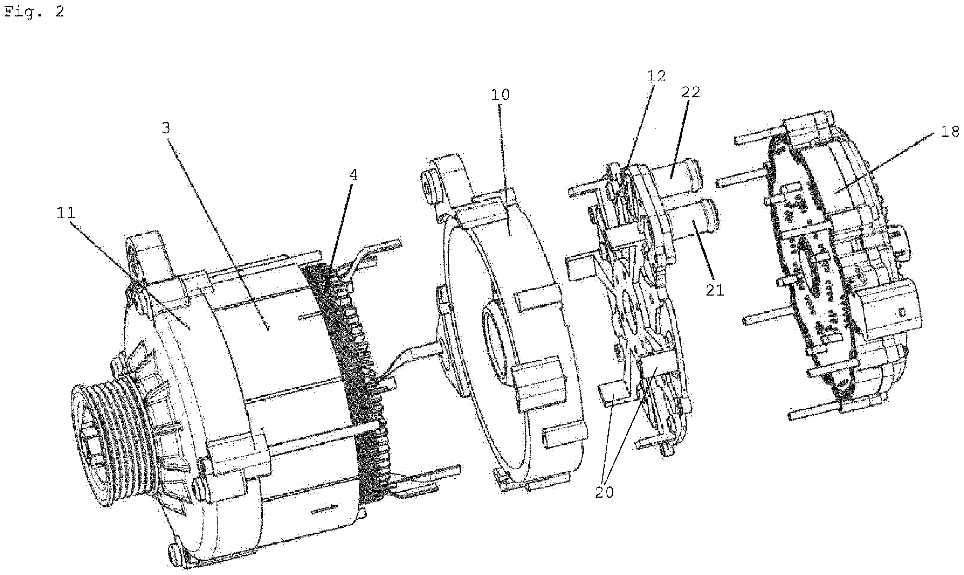

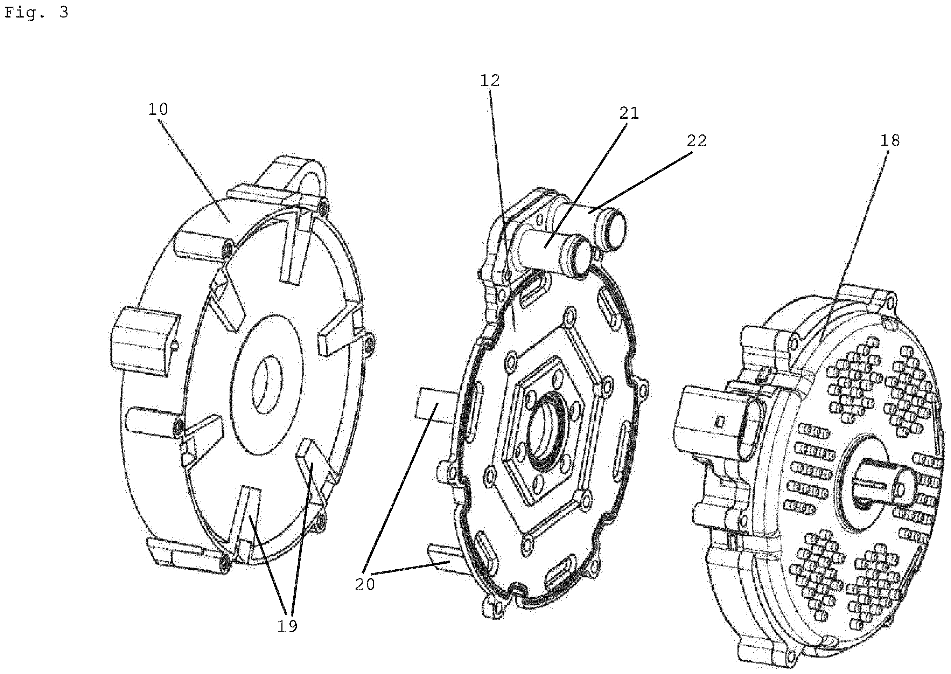

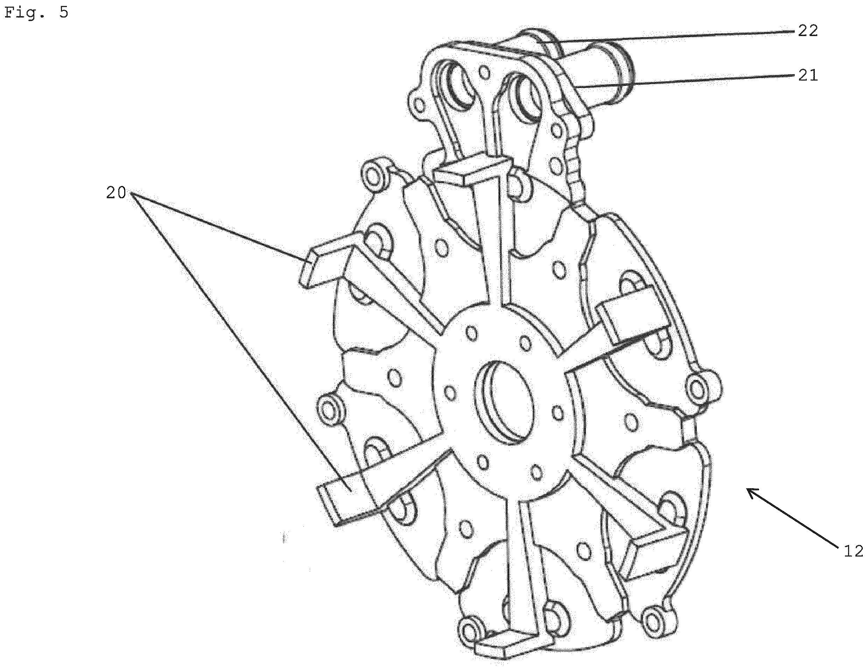

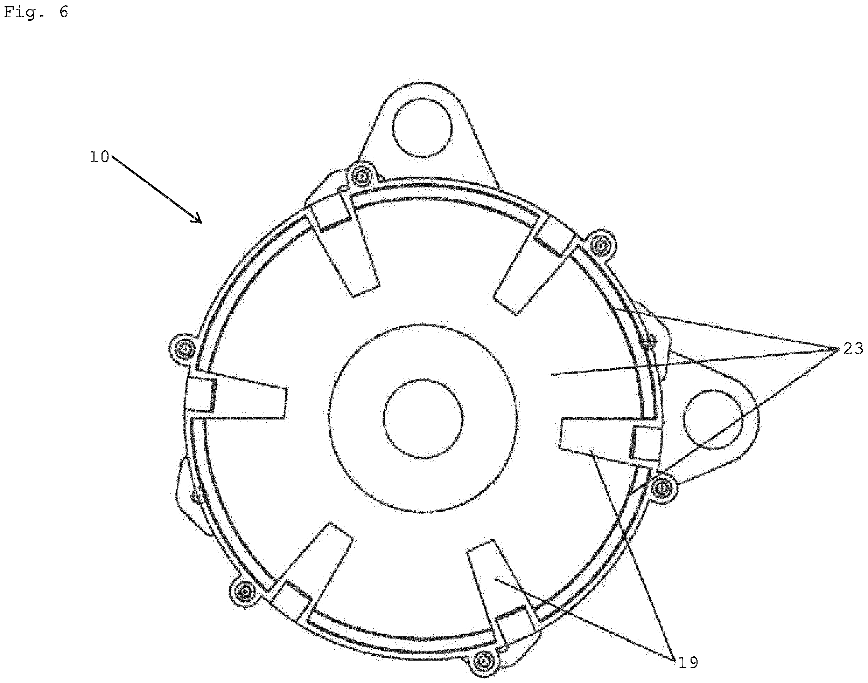

Fig. 2 bis 6 zeigen eine weitere elektrische Maschine 1 mit einem in Fig. 2 von rechts nach links gezeigten Invertergehäuse 18, einer Kühlmittelverteilerplatte 12, einem ersten Lagerschild 10, einem Wickelkopf 4 eines Stators 2, einem Stator-Blechpaket 3 und einem zweiten Lagerschild 11. Vertikale Stege 19 und axiale Stege 20 ragen in einen durch den ersten Lagerschild 10 und die Kühlmittelverteilerplatte 12 im zusammengebauten Zustand der elektrischen Maschine gebildeten Kühlkanal hinein, wobei sich die vertikalen Stege 19 und die axialen Stege 20 um die Drehachse D der elektrischen Maschine 1 herum mit Abstand zueinander abwechseln und dazu eingerichtet sind, ein Kühlmedium innerhalb des Kühlkanals zu leiten.

Die axialen Stege 20 werden durch die Kühlmittelverteilerplatte 12 und die vertikalen Stege 19 durch den ersten Lagerschild 10 ausgebildet und tragen dazu bei, dass ein mäanderförmiger dreidimensionaler Kühlkanal gebildet wird. Indem die genannten axialen Stege 20 und vertikalen Stege 19 jeweils abwechselnd in radialer Richtung im Kühlkanal angeordnet sind und in radialer Richtung zueinander versetzt angeordnet sind, entsteht ein Kühlkanal, bei dem das Kühlmedium von einem Zulaufanschluss 21 an einem ersten Ende des Kühlkanals zu einem Ablaufanschluss 22 an einem dem ersten Ende gegenüberliegenden zweiten Ende des Kühlkanals im Wesentlichen in radialer Richtung strömt und an den Enden der Stege 19, 20 in seiner Bewegungsrichtung um in etwa 180° umgelenkt wird. Weiterhin können die axialen Stege 20 der Kühlmittelverteilerplatte 12 in entsprechende Vertiefungen 23 des ersten Lagerschilds 10 eingreifen.

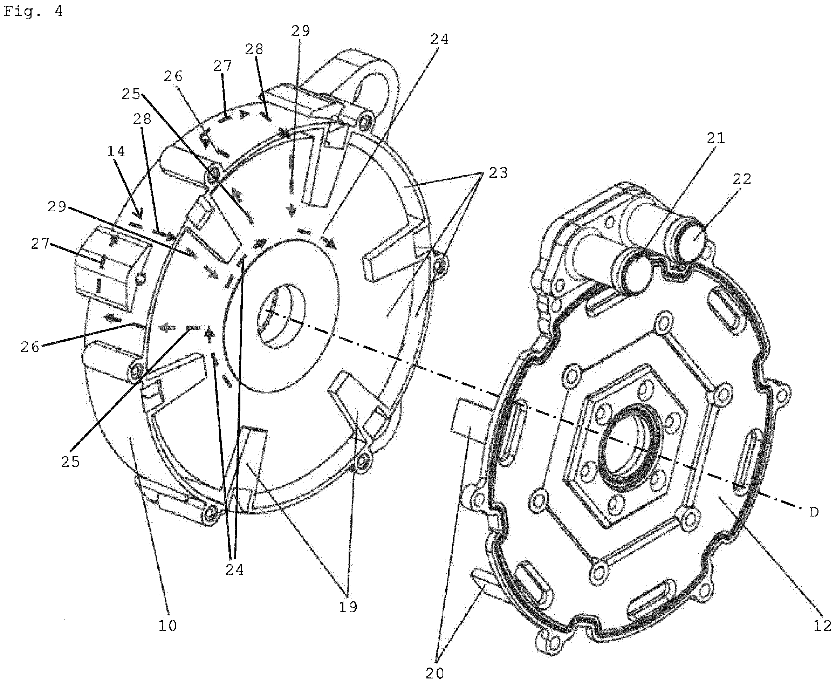

Fig. 4 zeigt mit gestrichelten Pfeillinien den Verlauf des dreidimensional mäanderförmig verlaufenden Kühlkanals 14, welcher durch den ersten Lagerschild 10 und die Kühlmittelverteilerplatte 12 in deren zusammengebautem Zustand gebildet wird. Dabei weist der Kühlkanal 14 die folgende, sich wiederholende Abfolge unterschiedlicher Kühlkanalabschnitte auf:
Ein erster Umfangskühlabschnitt 24 verläuft radial betrachtet im Bereich eines nicht durch Fig. 2 bis 6 gezeigten Rotors der elektrischen Maschine 1 ein Stück weit um die Drehachse D der elektrischen Maschine herum und geht in einen ersten vertikalen Kühlkanalabschnitt 25 über, welcher radial nach außen bis zu einem Bereich des Wickelkopfs 4 des Stators 2 verläuft und in einen ersten horizontalen Kühlabschnitt 26 übergeht, welcher sich beispielsweise in axialer Richtung der Wickelköpfe 4 erstreckt. Der horizontale Abschnitt 26 geht in einen zweiten Umfangskühlabschnitt 27 über, welcher radial und axial zu dem ersten Umfangskühlabschnitt 24 versetzt ein Stück weit um die Drehachse D herum verläuft und in einen zweiten axialen Kühlabschnitt 28 übergeht, welcher parallel und gegenläufig zu dem ersten axialen Kühlabschnitt 26 verläuft. Der zweite axiale Kühlabschnitt 28 geht in einen zweiten vertikalen Kühlabschnitt 29 über, welcher parallel und gegenläufig zu dem ersten vertikalen Kühlabschnitt 25 verläuft. Dadurch wird ein Abschnitt bzw. eine Schlinge eines dreidimensionalen Mäandermusters gebildet, welches durch eine Aneinanderreihung solcher Abschnitte bzw. Schlingen gebildet werden kann. Das Mäandermuster erstreckt sich umfänglich zwischen dem Zulaufanschluss 21 und dem Ablaufanschluss 22, das heißt es liegt im Zusammengebauten Zustand von Kühlmittelverteilerplatte 12 und erstem Lagerschild 10 ein dreidimensional radial umlaufender mäanderförmiger Kühlkanal 14 vor, welcher durch horizontale Kühlkanalabschnitte 26, 28, vertikale Kühlkanalabschnitte 25, 29 und Umfangskühlkanalabschnitte 24, 27 gebildet wird. Durch den Kühlkanal 14 kann ein Kühlmedium geleitet werden, z.B. Öl, Wasser oder Glykol.

## Patentansprüche

1. Kühlsystem für eine elektrische Maschine (1), welche einen Stator mit einem Stator-Blechpaket (3), mit im Stator-Blechpaket (3) eingebrachten Spulenwicklungen mit axial überstehenden Wickelköpfen (4), und einen Rotor (5) mit einem auf einer Rotorwelle (6) sitzenden Rotor-Blechpaket (7) umfasst, das Kühlsystem umfassend wenigstens einen Lagerschild (10, 11) und wenigstens eine Kühlmittelverteilerplatte (12, 13), wobei der Lagerschild (10, 11) und die Kühlmittelverteilerplatte (12, 13) dazu eingerichtet sind, gemeinsam einen Kühlkanal (14) auszubilden, wobei der Kühlkanal (14)
- mehrere horizontale Kühlkanalabschnitte (15, 16; 26, 28) umfasst, welche parallel zu einer Drehachse (D) der elektrischen Maschine (1) verlaufen,
- mehrere vertikale Kühlkanalabschnitte (17; 25, 29) umfasst, welche senkrecht zu der Drehachse (D) der elektrischen Maschine (1) verlaufen, und
- mehrere Umfangskühlkanalabschnitte (24, 27) umfasst, welche um die Drehachse (D) der elektrischen Maschine (1) herum verlaufen, wobei sich die drei unterschiedlichen Kühlkanalabschnitte (15, 16; 26, 28; 17; 25, 29; 24, 27) derart aneinander anschließen, dass der Kühlkanal (14) wenigstens bereichsweise einen dreidimensionalen mäanderförmigen Verlauf aufweist,
das Kühlsystem pro Kühlkanal (14) jeweils einen von mehreren ersten horizontalen Kühlkanalabschnitten (15) aufweist, welcher radial betrachtet im äußeren Bereich des Rotor-Blechpakets (7) und im inneren Bereich des Wickelkopfs (4) verläuft und sich axial entlang des Wickelkopfs (4) erstreckt,
das Kühlsystem pro Kühlkanal jeweils einen von mehreren zweiten horizontalen Kühlkanalabschnitten (16) aufweist, welcher radial betrachtet weiter außen als der erste horizontale Kühlkanalabschnitt (15) verläuft und sich axial entlang eines äußeren Umfangs des Wickelkopfs (4) erstreckt,
die ersten und zweiten Kühlkanalabschnitte (15, 16) in axialer Richtung derart parallel zu dem Wickelkopf (4) entlang des ersten Lagerschilds (10) verlaufen, so dass der radial innere Bereich und der radial äußere Bereich des Wickelkopfs in axialer Richtung zu einem Großteil gekühlt werden können, und zwar mittelbar über den ersten Lagerschild (10) und mittels eines innerhalb des Kühlkanals fließenden Kühlmediums.

2. Kühlsystem nach Anspruch 1, **dadurch gekennzeichnet, dass** vertikale Stege (19) und axiale Stege (20) in den Kühlkanal (14) hineinragen, wobei sich die vertikalen Stege (19) und die axialen Stege (20) um die Drehachse (D) der elektrischen Maschine (1) herum mit Abstand zueinander abwechseln und dazu eingerichtet sind, ein Kühlmedium innerhalb des Kühlkanals (14) zu leiten.

3. Kühlsystem nach einem der vorstehenden Ansprüche, **dadurch gekennzeichnet, dass** in dem Kühlkanal (14) wenigstens eine Querrippe angeordnet ist.

4. Kühlsystem nach einem der vorstehenden Ansprüche, **dadurch gekennzeichnet, dass** in dem Kühlkanal (14) wenigstens eine Längsrippe angeordnet ist.

5. Kühlsystem nach einem der vorstehenden Ansprüche, **dadurch gekennzeichnet, dass** der Kühlkanal (14) wenigstens bereichsweise eine aufgeraute Oberfläche aufweist.

6. Kühlsystem nach einem der vorstehenden Ansprüche, **dadurch gekennzeichnet, dass** ein Invertergehäuse (18) an der Kühlmittelverteilerplatte (12) anliegt.

7. Kühlsystem nach einem der vorstehenden Ansprüche, **gekennzeichnet durch**
- zwei Lagerschilde (10, 11),
- zwei Kühlmittelverteilerplatten (12, 13) und
- eine Kühlmittelübergabeeinrichtung (K),
wobei
die Lagerschilde (10, 11) und Kühlmittelverteilerplatten (12, 13) jeweils auf einander gegenüberliegenden axialen Seiten der elektrischen Maschine (1) angeordnet sind und die Kühlmittelübergabeeinrichtung (19) eine Verbindungsleitung für Kühlmittel zwischen den Kühlmittelverteilerplatten (12, 13) ausbildet.

8. Elektrische Maschine (1) umfassend
- einen Stator (2) mit einem Stator-Blechpaket (3), wobei im Stator-Blechpaket (3) Spulenwicklungen mit axial überstehenden Wickelköpfen (4) eingebracht sind,
- einen Rotor (5) mit einem auf einer Rotorwelle (6) sitzenden Rotor-Blechpaket (7) und
- ein Kühlsystem nach einem der vorstehenden Ansprüche.

9. Elektrische Maschine (1) nach Anspruch 8, **dadurch gekennzeichnet, dass** wenigstens einer der Wickelköpfe (4) mit einem Kontaktelement umgeben ist.

## Claims

1. Cooling system for an electric machine (1), which comprises a stator with a stator laminated core (3), with coil windings with axially protruding winding heads (4) being inserted in the stator laminated core (3), and a rotor (5) with a rotor laminated core (7) seated on a rotor shaft (6), the cooling system comprising at least one bearing bracket (10, 11) and at least one coolant distributor plate (12, 13), wherein the bearing bracket (10, 11) and the coolant distributor plate (12, 13) are designed to jointly form a cooling channel (14), wherein the cooling channel (14)
- comprises multiple horizontal cooling channel sections (15, 16; 26, 28) which run parallel to an axis of rotation (D) of the electric machine (1),
- comprises multiple vertical cooling channel sections (17; 25, 29) which run perpendicular to the axis of rotation (D) of the electric machine (1), and
- comprises multiple circumferential cooling channel sections (24, 27) which run around the axis of rotation (D) of the electric machine (1),
wherein the three different cooling channel sections (15, 16; 26, 28; 17; 25, 29; 24, 27) adjoin one another such that the cooling channel (14) has a three-dimensional meandering profile at least in regions,
the cooling system has in each case one of several first horizontal cooling channel sections (15) per cooling channel (14), which first horizontal cooling channel sections, as viewed radially, run in the outer region of the rotor laminated core (7) and in the inner region of the winding head (4), and extend axially along the winding head (4),
the cooling system in each case has one of several second horizontal cooling channel sections (16) per cooling channel, which second horizontal cooling channel section, as viewed radially, runs further to the outside than the first horizontal cooling channel section (15) and extends axially along an outer circumference of the winding head (4),
the first and second cooling channel sections (15, 16) run in the axial direction parallel to the winding head (4) along the first bearing bracket (10), such that the radially inner region and the radially outer region of the winding head can be cooled over a great extent in an axial direction, specifically indirectly via the first bearing bracket (10) and by means of a cooling medium flowing within the cooling channel.

2. Cooling system according to Claim 1, **characterized in that** vertical webs (19) and axial webs (20) project into the cooling channel (14), wherein the vertical webs (19) and the axial webs (20) alternate around the axis of rotation (D) of the electric machine (1) with a spacing to one another and are designed to conduct a cooling medium within the cooling channel (14).

3. Cooling system according to one of the preceding claims, **characterized in that** at least one transverse rib is arranged in the cooling channel (14).

4. Cooling system according to one of the preceding claims, **characterized in that** at least one longitudinal rib is arranged in the cooling channel (14).

5. Cooling system according to one of the preceding claims, **characterized in that** the cooling channel (14) has a roughened surface at least in regions.

6. Cooling system according to one of the preceding claims, **characterized in that** an inverter housing (18) bears against the coolant distributor plate (12).

7. Cooling system according to one of the preceding claims, **characterized by**
- two bearing brackets (10, 11),
- two coolant distributor plates (12, 13), and
- a coolant transfer device (K),
wherein
the bearing brackets (10, 11) and coolant distributor plates (12, 13) are arranged in each case on mutually opposite axial sides of the electric machine (1), and the coolant transfer device (19) forms a connecting line for coolant between the coolant distributor plates (12, 13).

8. Electric machine (1), comprising
- a stator (2) with a stator laminated core (3), wherein coil windings with axially protruding winding heads (4) are inserted in the stator laminated core (3),
- a rotor (5) with a rotor laminated core (7) seated on a rotor shaft (6), and
- a cooling system according to one of the preceding claims.

9. Electric machine (1) according to Claim 8, **characterized in that** at least one of the winding heads (4) is surrounded by a contact element

## Revendications

1. Système de refroidissement pour une machine électrique (1), laquelle comporte un stator comprenant un empilage de tôles de stator (3), comprenant des enroulements de bobine incorporés dans l'empilage de tôles de stator (3) avec des têtes de bobine (4) en saillie dans le sens axial, et un rotor (5) comprenant un empilage de tôles de rotor (7) qui repose sur un arbre de rotor (6), le système de refroidissement comportant au moins un flasque (10, 11) et au moins une plaque de distribution de fluide de refroidissement (12, 13), le flasque (10, 11) et la plaque de distribution de fluide de refroidissement (12, 13) étant conçus pour former ensemble un canal de refroidissement (14), le canal de refroidissement (14)
- comportant plusieurs portions de canal de refroidissement horizontales (15, 16 ; 26, 28) qui suivent un tracé parallèle à un axe de rotation (D) de la machine électrique (1),
- comportant plusieurs portions de canal de refroidissement verticales (17 ; 25, 29) qui suivent un tracé perpendiculaire à l'axe de rotation (D) de la machine électrique (1), et
- comportant plusieurs portions de canal de refroidissement périphériques (24, 27) qui suivent un tracé autour de l'axe de rotation (D) de la machine électrique (1),
les trois portions de canal de refroidissement différentes (15, 16 ; 26, 28 ; 17 ; 25, 29 ; 24, 27) se raccordant les unes aux autres de telle sorte que le canal de refroidissement (14) présente au moins dans certaines portions un tracé tridimensionnel en forme de méandre,
le système de refroidissement possédant respectivement pour chaque canal de refroidissement (14) une parmi plusieurs premières portions de canal de refroidissement horizontales (15) qui, vue dans le sens radial, suit un tracé dans la zone extérieure de l'empilage de tôles de rotor (7) et dans la zone intérieure de la tête de bobine (4) et s'étend dans le sens axial le long de la tête de bobine (4),
le système de refroidissement possédant respectivement pour chaque canal de refroidissement une parmi plusieurs deuxièmes portions de canal de refroidissement horizontales (16) qui, vue dans le sens radial, suit un tracé plus à l'extérieur que la première portion de canal de refroidissement horizontale (15) et s'étend dans le sens axial le long d'un pourtour extérieur de la tête de bobine (4),
les première et deuxième portions de canal de refroidissement (15, 16) suivant, dans la direction axiale, un tracé parallèle à la tête de bobine (4) le long du premier flasque (10) de telle sorte que la zone radialement intérieure et la zone radialement extérieure de la tête de bobine peuvent être refroidie en grande partie dans le sens radial, et ce par le biais du premier flasque (10) et au moyen d'un fluide de refroidissement qui s'écoule à l'intérieur du canal de refroidissement.

2. Système de refroidissement selon la revendication 1, **caractérisé en ce que** des nervures verticales (19) et des nervures axiales (20) font saillie dans le canal de refroidissement (14), les nervures verticales (19) et les nervures axiales (20) étant alternées avec un écart entre elles autour de l'axe de rotation (D) de la machine électrique (1) et étant conçues pour conduire un fluide de refroidissement à l'intérieur du canal de refroidissement (14).

3. Système de refroidissement selon l'une des revendications précédentes, **caractérisé en ce qu'**au moins une membrure transversale est disposée dans le canal de refroidissement (14).

4. Système de refroidissement selon l'une des revendications précédentes, **caractérisé en ce qu'**au moins une membrure longitudinale est disposée dans le canal de refroidissement (14).

5. Système de refroidissement selon l'une des revendications précédentes, **caractérisé en ce que** le canal de refroidissement (14) possède une surface rugueuse au moins dans certaines zones.

6. Système de refroidissement selon l'une des revendications précédentes, **caractérisé en ce qu'**un boîtier d'onduleur (18) repose contre la plaque de distribution de fluide de refroidissement (12).

7. Système de refroidissement selon l'une des revendications précédentes, **caractérisé par**
- deux flasques (10, 11),
- deux plaques de distribution de fluide de refroidissement (12, 13),
- un dispositif de transfert de fluide de refroidissement (K) les flasques (10, 11) et les plaques de distribution de fluide de refroidissement (12, 13) étant respectivement disposés sur des côtés axiaux mutuellement opposés de la machine électrique (1) et le dispositif de transfert de fluide de refroidissement (19) formant une conduite de liaison pour le fluide de refroidissement entre les plaques de distribution de fluide de refroidissement (12, 13).

8. Machine électrique (1) comportant
- un stator (2) comprenant un empilage de tôles de stator (3), des enroulements de bobine avec des têtes de bobine (4) en saillie dans le sens axial étant incorporés dans l'empilage de tôles de stator (3),
- un rotor (5) comprenant un empilage de tôles de rotor (7) qui repose sur un arbre de rotor (6) et
- un système de refroidissement selon l'une des revendications précédentes.

9. Machine électrique (1) selon la revendication 8, **caractérisée en ce qu'**au moins l'une des têtes de bobine (4) est entourée par un élément de contact.
